# EUROPÄISCHE PATENTSCHRIFT

(11) **EP 2 052 100 B1**
(45) Veröffentlichungstag und Bekanntmachung des Hinweises auf die Patenterteilung: **21.05.2014**
(21) Anmeldenummer: 07801451.1
(22) Anmeldetag: 25.07.2007
(51) Int. Cl.: C23C 16/44, F28F 19/02

(54) **VERFAHREN ZUM HERSTELLEN VON BAUTEILEN IN EINEM MEDIUMKREISLAUF, WIE INSBESONDERE EINES WÄRMEÜBERTRAGERS**
PROCESS FOR PRODUCING COMPONENTS IN A MEDIUM-CONTAINING CIRCUIT, IN PARTICULAR A HEAT EXCHANGER
PROCÉDÉ DE FABRICATION DE COMPOSANTS DANS UN CIRCUIT DE FLUIDE, COMME EN PARTICULIER UN ÉCHANGEUR DE CHALEUR

(30) Priorität: 07.08.2006 DE 102006037076
(43) Veröffentlichungstag der Anmeldung: 29.04.2009
(73) Patentinhaber: Behr GmbH & Co. KG, 70469 Stuttgart (DE)
(72) Erfinder: SCHAPER, Jörg, 70806 Kornwestheim (DE); HOLLER, Sebastian, 70180 Stuttgart (DE); TRAUWEIN, Ingo, 74321 Bietigheim-Bissingen (DE); BOGER, Snjezana, 73734 Esslingen (DE); HOLZMANN, Frank, 71732 Tamm (DE)
(74) Vertreter: Grauel, Andreas
(86) Internationale Anmeldenummer: PCT/EP2007/006603
(87) Internationale Veröffentlichungsnummer: WO 2008/017382

(56) Entgegenhaltungen:
- EP-A- 0 846 787
- EP-A- 1 052 308
- WO-A-2005/089960
- DE-A1- 10 314 700

## Beschreibung

Die Erfindung betrifft ein Verfahren zum Herstellen von Bauteilen eines Mediumkreislaufs, wie insbesondere von Bauteilen eines Kühl-, Kältemittel- oder Abgaskreislaufs, insbesondere eines Wärmeübertragers, eines Ventils oder ähnlich und deren Teile, wobei das Bauteil mindestens eine Fläche aufweist, die mit einer Beschichtung versehen wird.

Aus dem US-Patent US 5,584,946 ist ein Vorbehandlungs- und Oberflächenbehandlungsverfahren auf Basis komplexer Fluoride der Elemente Bor, Zirkon, Hafnium und Titan bekannt. Aus dem US-Patent US 5,795,659 ist eine Aluminiumoberfläche mit den Metallen Zirkonium, Hafnium, Rhenium, Mangan, Titan, sowie mit Silikaten und Boraten zum Korrosionsschutz und Hochtemperaturkorrosionsschutz bekannt. Aus der deutschen Offenlegungsschrift DE197 08 808 A1 sind ein Verfahren und eine Vorrichtung zum Aufbringen von transparenten Schutzschichten auf Gegenständen bekannt, wobei Siliziumoxidschichten mittels CVD aufgebracht werden. Aus der Patentschrift DD 289 156 A5 ist ein Verfahren zur Herstellung von Siliziumdioxidschichten auf freiliegenden leicht oxidierbaren Metallschichten bekannt, wobei ein CVD-Verfahren mit vorgeschalteter Temperung in Silianatmosphäre zur Vermeidung einer unerwünschten Oxidation zur Anwendung kommt.

Aus der japanischen Zusammenfassung JP 62124274 ist ein CVD-Verfahren zur Beschichtung von Wärmetauschern mit AIN bei einer Temperatur von 800 Grad Celsius bekannt. Aus der deutschen Offenlegungsschrift DE 43 34 572 C2 sind ein Verfahren und eine Vorrichtung zur Beschichtung der Innenfläche stark gewölbter im Wesentlichen kalottenförmiger Substrate mittels CVD bekannt.

Die DE 103 14 700 A1 offenbart ein Verfahren zur Herstellung oberflächenmodifizierter Werkstücke, bei welchen die Oberfläche des Werkstücks als solche modifiziert wird.

Die WO 2005/089960 A1 offenbart ein Beschichtungsverfahren, bei welchem ein Plasmaprozess verwendet wird, um eine korrosionsschützende Schicht erzeugt wird.

Die EP 1 052 308 A2 offenbart ein Verfahren zur Beschichtung eines Wärmetauschers, bei welchem ein Prozessgas mit einer Plasmawelle aktiviert wird.

Aufgabe der Erfindung ist es, das Korrosionsverhalten von obigen Bauteilen, wie insbesondere eines Wärmeübertragers, eines Ventils oder ähnlich und deren Teile, zu verbessern.

Die Aufgabe ist bei einem Verfahren zum Herstellen eines eines Mediumkreislaufs, wie von Bauteilen eines Kühl-, Kältemittel- oder Abgaskreislaufs, oder eines Wärmeübertragers, eines Ventils oder ähnlich und/oder deren Teile, wobei das Bauteil mindestens eine Fläche aufweist, die mit einer Beschichtung versehen wird, dadurch gelöst, dass ein temperierter und mit mindestens einer reaktiven, gasförmigen Komponente beladener Gasstrom zu der ebenfalls temperierten Fläche des Bauteils, wie beispielsweise eines Wärmeübertragers, geführt wird, wo der Gasstrom auf der temperierten Fläche zu mindestens einer festen Schutzschicht, wie beispielsweise eine Korrosionsschutzschicht, mittels CVD-Verfahren reagiert, wobei der Gasstrom im Anschluss an einen stoffschlüssigen Fügeprozess des Bauteils einen Lötprozess, einen Schweißprozess oder einen mechanischen Fügeprozess zu der Fläche des Bauteils geführt wird.

Die reaktive, gasförmige Komponente wird auch als Precursor bezeichnet. Weitere gasförmige Reaktionsprodukte werden vorteilhaft über den Gasstrom abtransportiert. Durch das erfindungsgemäße Verfahren wird eine glasartige, keramische oder anderweitig oxidische Schutzschicht, wie eine Korrosionsschutzschicht, auf die Bauteiloberfläche aufgebracht. Mit dem erfindungsgemäßen Verfahren lässt sich eine abnehmende Schichtdicke in Strömungsrichtung des Gasstroms realisieren. Darüber hinaus ist durch die Strömungsführung eine lokale Erhöhung der Schichtdicke möglich. Die Beschichtung kann an allen Typen von Bauteilen, wie beispielsweise Wärmeübertragern, Ventilen oder Teilen davon aufgebracht werden, unabhängig vom Material, zum Beispiel Aluminium, Edelstahl, Magnesium oder Kupfer, und unabhängig von der Bauart, zum Beispiel an Scheiben-, Rundrohr-, Flachrohr- oder Stapelscheibenwärmeübertragern. Beschichtete Bauteile sind zum Beispiel Ladeluftkühler, Abgaswärmetauscher, Kühlmittelkühler, Heizkörper, Ölkühler, Verdampfer, Kondensatoren, Ventile oder Beauteile von Schichtwärmeübertragern oder für Brennstoffzellen.

Ein bevorzugtes Ausführungsbeispiel des Verfahrens ist dadurch gekennzeichnet, dass die zu beschichtende Fläche des Bauteils, wie beispielsweise des Wärmeübertragers, auf eine höhere Temperatur gebracht wird als der Gasstrom.

Ein weiteres bevorzugtes Ausführungsbeispiel des Verfahrens ist dadurch gekennzeichnet, dass die Fläche des Bauteils, wie beispielsweise des Wärmeübertragers, auf eine Temperatur von 100 bis 600 Grad Celsius, insbesondere 300 bis 550 Grad Celsius, insbesondere 350 bis 450 Grad Celsius, gebracht wird.

Das Aufbringen der Beschichtung kann Inline oder Offline erfolgen. Vorzugsweise wird die Beschichtung etwa bei Atmosphärendruck aufgebracht, das heißt bei einem Druck von etwa 101 300 Pascal. Ein bevorzugter Druckbereich erstreckt sich von 120 000 Pascal bis zu 80 000 Pascal.

Ein weiteres bevorzugtes Ausführungsbeispiel des Verfahrens ist dadurch gekennzeichnet, dass an den Ofen oder an die Aufheizvorrichtung ein Unterdruck angelegt wird. Der niedrigere Druck führt zu einer besseren dreidimensionalen Beschichtung.

Ein weiteres bevorzugtes Ausführungsbeispiel des Verfahrens ist dadurch gekennzeichnet, dass der Druck zwischen 101300 Pascal und 100 Pascal oder insbesondere zwischen 100 Pascal und 1 Pascal oder zwischen 1 Pascal und 0,001 Pascal beträgt. Durch die erfindungsgemäßen Druckbereiche können zum Beispiel Sacklöcher, poröse Strukturen und enge Kanäle gleichmäßig beschichtet werden.

Weiterhin ist es zweckmäßig, wenn der Gasstrom dem Bauteil direkt zugeführt wird oder durch das Bauteil selbst durchgeführt wird.

Ein weiteres bevorzugtes Ausführungsbeispiel des Verfahrens ist dadurch gekennzeichnet, dass der Unterdruck dazu verwendet wird, das Gas in den Ofen oder in die Aufheizvorrichtung oder zu dem Bauteil oder durch das Bauteil zu saugen. Auch kann es vorteilhaft zu einem gepulsten Druckverlauf während des Beschichtungsvorgangs kommen. Unter gepulstem Druckverlauf oder Druckpulsation wird ein Wechsel von Druckanstieg und Druckabfall verstanden.

Ein weiteres bevorzugtes Ausführungsbeispiel des Verfahrens ist dadurch gekennzeichnet, dass der Gasstrom einem Lötofen zugeführt wird, in dem der Wärmeübertrager vor dem Zuführen des Gasstroms verlötet wurde. Dadurch wird das Aufbringen der Beschichtung auf einfache Art und Weise in den Produktionsprozess des Wärmeübertragers eingebunden.

Ein weiteres bevorzugtes Ausführungsbeispiel des Verfahrens ist dadurch gekennzeichnet, dass als reaktives Gas ein Silan, ein Siliziumtetrachlorid und/oder mindestens eine siliziumorganische Verbindung, wie Siloxane oder Siliziumtetraacetat, zur Erzeugung einer Siliziumdioxidschicht verwendet werden beziehungsweise wird.

Ein weiteres bevorzugtes Ausführungsbeispiel des Verfahrens ist dadurch gekennzeichnet, dass als reaktives Gas Titanchlorid und/oder mindestens eine metallorganische, insbesondere eine titanorganische Verbindung, wie Titantetraäthylat oder Titantetraisopropylat, zur Erzeugung einer Titandioxidschicht verwendet werden beziehungsweise wird.

Ein weiteres bevorzugtes Ausführungsbeispiel des Verfahrens ist dadurch gekennzeichnet, dass als reaktives Gas Aluminiumchlorid und/oder mindestens eine metallorganische, insbesondere eine aluminiumorganische Verbindung, wie Aluminiumtriethylat, zur Erzeugung einer Aluminiumoxidschicht verwendet werden beziehungsweise wird.

Ein weiteres bevorzugtes Ausführungsbeispiel des Verfahrens ist dadurch gekennzeichnet, dass als reaktives Gas Zirkontetrachlorid und/oder mindestens eine metallorganische, insbesondere eine zirkonorganische Verbindung zur Erzeugung einer Zirkoniumoxidschicht verwendet werden beziehungsweise wird.

Ein weiteres bevorzugtes Ausführungsbeispiel des Verfahrens ist dadurch gekennzeichnet, dass mehrere reaktive Gase miteinander kombiniert werden, um eine Mischoxidschicht zu erzeugen. In der Mischoxidschicht können unterschiedliche Eigenschaften miteinander kombiniert werden.

Ein weiteres Merkmal des Verfahrens ist dadurch gekennzeichnet, dass die Schutzschicht, wie beispielsweise Korrosionsschutzschicht, durch ein CVD (Chemical Vapor Deposition)-Verfahren aufgebracht wird. Gemäß einem wesentlichen Aspekt der Erfindung wird das CVD-Verfahren für Wärmeübertrager angewendet. Insbesondere wird das CVD-Verfahren in Kombination mit dem Lötprozess von Wärmeübertragern angewendet.

Ein weiteres bevorzugtes Ausführungsbeispiel des Verfahrens ist dadurch gekennzeichnet, dass auf die Schutzschicht, wie beispielsweise Korrosionsschutzschicht, mindestens eine weitere Schicht aufgebracht wird. Die weitere Schicht kann unterschiedliche funktionelle Eigenschaften haben.

Weiterhin ist es zweckmäßig, wenn die Schutzschicht eine Korrosionsschutzschicht und/oder eine Diffusionsbarriere ist.

Ein weiteres bevorzugtes Ausführungsbeispiel des Verfahrens ist dadurch gekennzeichnet, dass die weitere Schicht oder eine der weiteren Schichten biozide, antiadhäsive und/oder hydrophile/hydrophobe Eigenschaften aufweist und/oder eine Schutzschicht und/oder eine Diffusionsbarriere ist. Vorzugsweise enthält die biozide Schicht Silber oder Silbersalze beziehungsweise -oxide.

Ein weiteres bevorzugtes Ausführungsbeispiel des Verfahrens ist dadurch gekennzeichnet, dass die Schutzschicht und/oder die weitere Schicht oder eine der weiteren Schichten eine strukturierte Oberfläche aufweist. Bei der strukturierten Oberfläche kommt zum Beispiel der Lotuseffekt oder eine Haifischhaut zur Anwendung.

Ein weiteres bevorzugtes Ausführungsbeispiel des Verfahrens ist dadurch gekennzeichnet, dass die Schutzschicht und/oder die weitere Schicht photokatalytische Eigenschaften aufweist. Vorzugsweise enthält die Schutzschicht und/oder die weitere Schicht Titandioxid, das in Kombination mit UV-Licht biozide Eigenschaften aufweist. Als UV-Lichtquelle können LED's oder handelsübliche UV-Lampen eingesetzt werden.

Ein weiteres bevorzugtes Ausführungsbeispiel des Verfahrens ist dadurch gekennzeichnet, dass die weitere Schicht durch ein CVD (Chemical Vapor Deposition)-Verfahren direkt im Anschluss an die Schutzschicht und/oder die Korrosionsschutzschicht, insbesondere die Siliziumdioxidschicht, aufgebracht wird.

Ein weiteres bevorzugtes Ausführungsbeispiel des Verfahrens ist dadurch gekennzeichnet, dass die weitere Schicht in einem separaten Prozess durch ein PVD(Physical Vapor Deposition)-Verfahren aufgebracht wird.

Ein weiteres bevorzugtes Ausführungsbeispiel des Verfahrens ist dadurch gekennzeichnet, dass die weitere Schicht in einem separaten Prozess durch Lackieren oder elektrochemisches Abscheiden aufgebracht wird.

Ein weiteres bevorzugtes Ausführungsbeispiel des Verfahrens ist dadurch gekennzeichnet, dass durch eine Hintereinanderschaltung von mehreren Beschichtungsprozessen eine mehrlagige Beschichtung erzeugt wird.

Ein weiteres bevorzugtes Ausführungsbeispiel des Verfahrens ist dadurch gekennzeichnet, dass als Trägergas Luft, Stickstoff, Sauerstoff, Wasserstoff und/oder mindestens ein Edelgas verwendet wird.

Ein weiteres bevorzugtes Ausführungsbeispiel des Verfahrens ist dadurch gekennzeichnet, dass die Dicke der mindestens einen Schutzschicht und/oder der Korrosionsschutzschicht durch Variation der Prozessparameter, wie die Beschichtungsdauer, die Ofentemperatur, die Gastemperatur, die Strömungsgeschwindigkeit, die Strömungsführung und/oder die Precursorkonzentration im Gasstrom, variiert wird.

Ein weiteres bevorzugtes Ausführungsbeispiel des Verfahrens ist dadurch gekennzeichnet, dass die Dicke der mindestens einen Schutzschicht und/oder der Korrosionsschutzschicht unter 1000 Nanometer, insbesondere zwischen 100 und 500 Nanometer, beträgt. Mit dem erfindungsgemäßen Verfahren wird sichergestellt, dass trotz der unterschiedlichen Wärmedehnungen der Korrosionsschutzschicht und des Grundmaterials keine Risse oder Abplatzungen auftreten.

Ein weiteres bevorzugtes Ausführungsbeispiel des Verfahrens ist dadurch gekennzeichnet, dass eine Rohrinnenseite des Wärmeübertragers mit der Beschichtung versehen wird. Um dies zu erreichen, wird bei dem erfindungsgemäßen Verfahren eine gezielte Strömungsführung des Gasstroms durch das Rohr verwendet. Vorzugsweise erfolgt am Rohrende eine Absaugung. Die Beschichtung lässt sich mit dem erfindungsgemäßen Verfahren auch dann noch realisieren, wenn es sich nicht um ein Rohr mit einer Innenfläche, sondern um ein -zum Zwecke der besseren Wärmeübertragungstrukturiertes Rohr oder um ein Rohr mit Turbulenzeinbauten handelt. Mit dem erfindungsgemäßen Verfahren kann auch der Innenraum eines Stapelscheibenwärmeübertragers beschichtet werden.

Ein weiteres bevorzugtes Ausführungsbeispiel des Verfahrens ist dadurch gekennzeichnet, dass eine Rohraußenseite des Wärmeübertragers mit der Beschichtung versehen wird. Mit dem erfindungsgemäßen Verfahren ist es möglich, kompliziert geformte, dreidimensionale Strukturen, wie bei einem Wärmeübertrager mit feinen Wellrippen, Kiemen oder Turbulenzeinbauten, gleichmäßig zu beschichten.

Weiterhin ist es zweckmäßig, wenn eine Fläche eines Bauteil eines Wärmeübertragers, wie eines Verdampfers, eines Abgaskühlers, Ladeluftkühlers, eines Kühlmittelkühlers, oder einer Komponente in einem Fluidstrom, wie eines Gasstroms oder eines Flüssigkeitsstroms, wie beispielsweise eines Ventils, eines Elements eines Schichtwärmeübertragers beispielsweise für eine Brennstoffzelle beschichtet wird.

Bei einem Bauteil, wie beispielsweise einem Wärmeübertrager, mit mindestens einer Fläche ist die vorab angegebene Aufgabe dadurch gelöst, dass die mindestens eine Fläche mit einer Beschichtung gemäß einem vorab beschriebenen Verfahren versehen ist.

Weiterhin ist es zweckmäßig, wenn das Bauteil ein Wärmeübertrager, wie ein Verdampfer, ein Abgaskühler, ein Ladeluftkühler, ein Kühlmittelkühler oder eine Komponente in einem Fluidstrom, wie in einem Gasstroms oder in einem Flüssigkeitsstrom ist, wie beispielsweise ein Ventil, ein Element eines Schichtwärmeübertragers beispielsweise einer Brennstoffzelle ist.

Ein bevorzugtes Ausführungsbeispiel des Bauteils, wie beispielsweise des Wärmeübertragers, ist dadurch gekennzeichnet, dass die Beschichtung eine glasartige, keramische oder anderweitig oxidische Korrosionsschutzschicht umfasst.

Ein weiteres bevorzugtes Ausführungsbeispiel des Bauteils, wie beispielsweise des Wärmeübertragers, ist dadurch gekennzeichnet, dass die Beschichtung eine in Strömungsrichtung des Gasstroms abnehmende Schichtdicke aufweist.

Ein weiteres bevorzugtes Ausführungsbeispiel des Bauteils, wie beispielsweise des Wärmeübertragers, ist dadurch gekennzeichnet, dass die Beschichtung mindestens eine lokale Erhöhung der Schichtdicke aufweist.

Obwohl eine Oxidschicht prinzipiell den Wärmeübergang verschlechtert, kann dies bei einer Schichtdicke von weniger als 1 µm als vernachlässigbar betrachtet werden. Die Wärmeübertragerleistung eines beschichteten Bauteils entspricht damit dem eines unbeschichteten Bauteils.

Vorteilhaft ist, dass als reaktives Gas Aluminiumchlorid und/oder mindestens eine metallorganische, insbesondere eine aluminiumorganische Verbindung, wie Aluminiumtriethylat, zur Erzeugung einer Aluminiumoxidschicht verwendet werden beziehungsweise wird.

Vorteilhaft ist, dass als reaktives Gas Zirkontetrachlorid und/oder mindestens eine metallorganische, insbesondere eine zirkonorganische Verbindung zur Erzeugung einer Zirkoniumoxidschicht verwendet werden beziehungsweise wird.

Vorteilhaft ist, dass mehrere reaktive Gase miteinander kombiniert werden, um eine Mischoxidschicht zu erzeugen.

Die Schutzschicht wird durch ein CVD (Chemical Vapor Deposition)-Verfahren aufgebracht.

Vorteilhaft ist, dass auf die Schutzschicht mindestens eine weitere Schicht aufgebracht wird.

Vorteilhaft ist, dass die Schutzschicht eine Korrosionsschutzschicht und/oder eine Diffusionsbarriere ist.

Vorteilhaft ist, dass die weitere Schicht oder eine der weiteren Schichten biozide, antiadhäsive und/oder hydrophile/hydrophobe Eigenschaften aufweist und/oder eine Schutzschicht ist und/oder eine Diffusionsbarriere ist.

Vorteilhaft ist, dass die Schutzschicht und/oder die weitere Schicht oder eine der weiteren Schichten eine strukturierte Oberfläche aufweist.

Vorteilhaft ist, dass die Schutzschicht und/oder die weitere Schicht fotokatalytische Eigenschaften aufweist.

Vorteilhaft ist, dass die Schutzschicht und/oder die weitere Schicht Titandioxid enthält.

Vorteilhaft ist, dass die weitere Schicht durch ein CVD(Chemical Vapor Deposition)-Verfahren direkt im Anschluss an die Schutzschicht, insbesondere die Siliziumdioxidschicht, aufgebracht wird.

Vorteilhaft ist, dass die weitere Schicht in einem separaten Prozess durch ein PVD(Physical Vapor Deposition)-Verfahren aufgebracht wird.

Vorteilhaft ist, dass die weitere Schicht in einem separaten Prozess durch Lackieren oder elektrochemisches Abscheiden aufgebracht wird.

Vorteilhaft ist, dass durch eine Hintereinanderschaltung von mehreren Beschichtungsprozessen eine mehrlagige Beschichtung erzeugt wird.

Vorteilhaft ist, dass als Trägergas Luft, Stickstoff, Sauerstoff, Wasserstoff und/oder mindestens ein Edelgas verwendet wird.

Vorteilhaft ist, dass die Dicke der mindestens einen Schutzschicht durch Variation der Prozessparameter, wie die Beschichtungsdauer, die Ofentemperatur, die Gastemperatur, die Strömungsgeschwindigkeit, die Strömungsführung und/oder die Precursorkonzentration im Gasstrom, variiert wird.

Vorteilhaft ist, dass die Dicke der mindestens einen Schutzschicht unter 1000 Nanometer, insbesondere zwischen 100 und 500 Nanometer, beträgt.

Vorteilhaft ist, dass eine Rohrinnenseite des Wärmeübertragers mit der Beschichtung versehen wird.

Vorteilhaft ist, dass eine Rohraußenseite des Wärmeübertragers mit der Beschichtung versehen wird.

Vorteilhaft ist, dass eine Fläche eines Bauteil eines Wärmeübertragers, wie eines Verdampfers, eines Abgaskühlers, Ladeluftkühlers, eines Kühlmittelkühlers, oder einer Komponente in einem Fluidstrom, wie eines Gasstroms oder eines Flüssigkeitsstroms, wie beispielsweise eines Ventils, eines Elements eines Schichtwärmeübertragers für eine Brennstoffzelle beschichtet wird.

Vorteilhaft ist, dass das Bauteil ein Wärmeübertrager, wie ein Verdampfer, ein Abgaskühler, ein Ladeluftkühler, ein Kühlmittelkühler oder eine Komponente in einem Fluidstrom, wie in einem Gasstroms oder in einem Flüssigkeitsstrom ist, wie beispielsweise ein Ventil, ein Element eines Schichtwärmeübertragers für eine Brennstoffzelle ist.

Vorteilhaft ist, dass die Beschichtung eine glasartige, keramische oder anderweitig oxidische Schutzschicht, wie beispielsweise Korrosionsschutzschicht umfasst.

Vorteilhaft ist, dass die Beschichtung eine abnehmende Schichtdicke in Strömungsrichtung des Gasstroms aufweist.

Vorteilhaft ist, dass die Beschichtung mindestens eine lokale Erhöhung der Schichtdicke aufweist.

Weitere Vorteile, Merkmale und Einzelheiten der Erfindung ergeben sich aus der nachfolgenden Beschreibung, in der unter Bezugnahme auf die Zeichnung verschiedene Ausführungsbeispiele im Einzelnen beschrieben sind. Es zeigen:
- Figur 1: eine schematische Darstellung eines Inline-Beschichtungsverfahrens mit einem Lötofen und einem Beschichtungsofen;
- Figur 2: ein Offline-Verfahren mit einem Lötofen und
- Figur 3: ein Offline-Beschichtungsverfahren mit einem Beschichtungsofen.

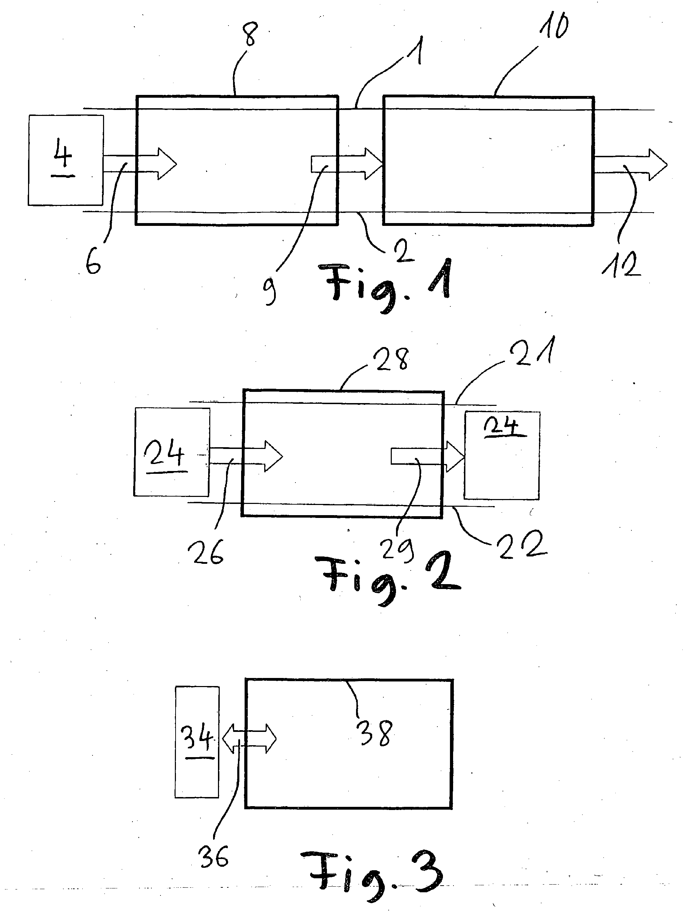

In Figur 1 ist durch zwei gerade Linien 1 und 2 ein Transportweg einer Inline-Produktionslinie zur Herstellung von Wärmetauschern angedeutet. Ein Warenträger 4 mit Wärmeübertragern wird, wie durch einen Pfeil 6 angedeutet ist, entlang dem Transportweg 1, 2 einem Lötofen 8 zugeführt. Durch einen Pfeil 9 ist angedeutet, dass der Warenträger 4 entlang dem Transportweg 1, 2 nach dem Lötofen 8 in einen CVD-Beschichtungsofen 10 transportiert wird. Durch einen Pfeil 12 ist angedeutet, wie der fertige Wärmeübertrager den CVD-Beschichtungsofen 10 verlässt.

Bei dem in Figur 1 dargestellten Lötofen 8 und dem CVD-Beschichtungsofen 10 handelt es sich um Durchlauföfen. Zunächst werden die Wärmeübertrager im Durchlaufbetrieb in dem Lötofen 8 verlötet. Durch den Pfeil 9 ist angedeutet, dass die verlöteten Wärmeübertrager ohne Abkühlung direkt in den CVD-Beschichtungsofen gefahren werden, wo sie mit der Korrosionsschutzschicht beschichtet werden. Dabei kann die Restwärme des verlöteten Wärmeübertragers zum Beschichten mittels CVD verwendet werden. Dadurch kann Energie beim Beschichten eingespart werden.

Wenn der Fügeprozess, zum Beispiel Vakuumlöten, in einem Kammerofen durchgeführt wird, dann kann die Beschichtung in demselben Ofen, zeitlich direkt im Anschluss an den Fügeprozess durchgeführt werden. Dazu wird die Temperatur nach dem Fügeprozess auf die Beschichtungstemperatur eingestellt, das heißt, die Wärmeübertrager in dem Kammerofen werden abgekühlt oder aufgeheizt. Dann wird das mit Precursor beladene Gas in den Kammerofen eingeleitet. Von besonderem Vorteil ist dabei ein Kammerofen, in dem ein Niederdruckfügeverfahren Verwendung findet. Der niedrige Druck wirkt dabei positiv auf gleichmäßige dreidimensionale Beschichtung. Da der Kammerofen, der sowohl zum Löten als auch zum Beschichten verwendet wird, im so genannten Batchbetrieb betrieben wird, wird der Kammerofen auch als Batchofen bezeichnet.

In den Figuren 2 und 3 ist angedeutet, wie das erfindungsgemäße Verfahren im Offline-Betrieb angewendet werden kann. Durch gerade Linien 21, 22 ist ein Transportweg durch einen Lötofen 24 angedeutet. In Figur 2 wird ein Warenträger 24 mit Wärmeübertragern dem Lötofen 28 zugeführt, wie durch einen Pfeil 26 angedeutet ist. In dem Lötofen 28 werden die Wärmeübertrager verlötet. Nach dem Verlöten wird der Warenträger 24 aus dem Lötofen 28 herausgefahren, wie durch einen Pfeil 29 angedeutet ist.

In Figur 3 ist angedeutet, dass ein weiterer Warenträger 34 mit verlöteten Wärmeübertragern einem CVD-Beschichtungsofen 38 zugeführt wird. Das Zuführen und Abführen des Warenträgers 34 ist durch einen Doppelpfeil 36 angedeutet. Bei der in den Figuren 2 und 3 dargestellten Offline-Bearbeitung kühlen die Bauteile auf Umgebungstemperatur ab, werden umgesetzt und in dem CVD-Beschichtungsofen 38 wieder auf Temperatur gebracht und beschichtet.

Durch das erfindungsgemäße Verfahren kann die Korrosionsbeständigkeit von Warenträgern, speziell gegen aggressive Säuren, verbessert werden. Dadurch können die Wandstärken der Wärmeübertrager reduziert werden und die Wärmeübertrager können kompakter gebaut werden, was zu einer Materialeinsparung führt. Durch die Wandstärkenreduktion kann darüber hinaus die Leistung des Wärmeübertragers verbessert werden. Die glasartige Beschichtung hat den Vorteil, dass sie geruchsneutral ist. Durch die Erzeugung einer hydrophilen Oberfläche kann der Wasser-/Kondensatablauf verbessert werden.

## Patentansprüche

1. Verfahren zum Herstellen eines Bauteiles eines Mediumkreislaufs, wie von Bauteilen eines Kühl-, Kältemittel- oder Abgaskreislaufs, oder eines Wärmeübertragers, eines Ventils und/oder deren Teile, wobei das Bauteil mindestens eine Fläche aufweist, die mit einer Beschichtung versehen wird, **dadurch gekennzeichnet, dass** ein temperierter und mit mindestens einer reaktiven, gasförmigen Komponente beladener Gasstrom zu der ebenfalls temperierten Fläche des Bauteils geführt wird, wo der Gasstrom auf der temperierten Fläche zu mindestens einer festen Schutzschicht mittels CVD-Verfahren reagiert, wobei der Gasstrom im Anschluss an einen stoffschlüssigen Fügeprozess des Bauteils einen Lötprozess, einen Schweißprozess oder einen mechanischen Fügeprozess zu der Fläche des Bauteils geführt wird.

2. Verfahren nach Anspruch 1, **dadurch gekennzeichnet, dass** die zu beschichtende Fläche des Bauteils auf eine höhere Temperatur gebracht wird als der Gasstrom.

3. Verfahren nach einem der vorhergehenden Ansprüche, **dadurch gekennzeichnet, dass** die Fläche des Bauteils auf eine Temperatur von 100 bis 600 Grad Celsius, insbesondere 300 bis 550 Grad Celsius, insbesondere 350 bis 450 Grad Celsius, vorzugsweise 400°C gebracht wird.

4. Verfahren nach einem der Ansprüche 1 bis 3, **dadurch gekennzeichnet, dass** die Aufheizvorrichtung eine induktive Aufheizvorrichtung ist.

5. Verfahren nach einem der Ansprüche 1 bis 4, **dadurch gekennzeichnet, dass** an den Ofen oder an die Aufheizvorrichtung ein Unterdruck angelegt wird.

6. Verfahren nach Anspruch 5, **dadurch gekennzeichnet, dass** der Druck zwischen 101300 Pascal und 100 Pascal oder zwischen 100 Pascal und 1 Pascal, insbesondere zwischen 1 Pascal und 0,001 Pascal beträgt.

7. Verfahren nach einem der vorhergehenden Ansprüche, **dadurch gekennzeichnet, dass** der Gasstrom dem Bauteil direkt zugeführt wird oder durch das Bauteil selbst durchgeführt wird.

8. Verfahren nach einem der vorhergehenden Ansprüche, **dadurch gekennzeichnet, dass** der Unterdruck dazu verwendet wird, das Gas beziehungsweise den Gasstrom zu dem Bauteil oder durch das Bauteil zu saugen.

9. Verfahren nach Anspruch 8, **dadurch gekennzeichnet, dass** es zu einem gepulsten Druckverlauf während des Beschichtungsvorgangs kommt.

10. Verfahren nach einem der vorhergehenden Ansprüche, **dadurch gekennzeichnet, dass** der Gasstrom einem Lötofen zugeführt wird, in dem der Wärmeübertrager vor dem Zuführen des Gasstroms verlötet wurde.

11. Verfahren nach einem der vorhergehenden Ansprüche, **dadurch gekennzeichnet, dass** als reaktives Gas ein Silan, ein Siliziumtetrachlorid und/oder mindestens eine siliziumorganische Verbindung, wie Siloxane oder Siliziumtetraacetat, zur Erzeugung einer Siliziumdioxidschicht verwendet werden beziehungsweise wird.

12. Verfahren nach einem der vorhergehenden Ansprüche, **dadurch gekennzeichnet, dass** als reaktives Gas Titanchlorid und/oder mindestens eine metallorganische, insbesondere eine titanorganische Verbindung, wie Titantetraäthylat oder Titantetraisopropylat, zur Erzeugung einer Titandioxidschicht verwendet werden beziehungsweise wird.

## Claims

1. A method for producing a component part of a medium-containing circuit such as component parts of a cooling circuit, refrigeration circuit or exhaust gas circuit, or of a heat exchanger, a valve and/or parts thereof, wherein the component part has at least one surface that is provided with a coating, **characterized in that** a temperature-controlled gas flow laden with at least one reactive, gaseous component is fed to the likewise temperature-controlled surface of the component part, where the gas flow reacts on the temperature-controlled surface so as to form at least one solid protective layer by means of the CVD method, wherein subsequent to a firmly bonding joining process of the component part, in particular a soldering process, a welding process or a mechanical joining process, the gas flow is fed to the surface of the component part.

2. The method according to claim 1, **characterized in that** the component part's surface to be coated is brought to a higher temperature than the gas flow.

3. The method according to any one of the preceding claims, **characterized in that** the surface of the component part is brought to a temperature of 100 to 600 degrees Celsius, in particular 300 to 550 degrees Celsius, in particular 350 to 450 degrees Celsius, preferably 400°C.

4. The method according to any one of the claims 1 to 3, **characterized in that** the heating device is an inductive heating device.

5. The method according to any ane of the claims 1 to 4, **characterized in that** low-pressure is applied to the furnace or the heating device.

6. The method according to claim 5, **characterized in that** the pressure ranges between 101300 Pascal and 100 Pascal or between 100 Pascal and 1 Pascal, in particular between 1 Pascal and 0.001 Pascal.

7. The method according to any one of the preceding claims, **characterized in that** the gas flow is fed directly to the component part or is fed through the component part itself.

8. The method according to any one of the preceding claims, **characterized in that** the low-pressure is used for suctioning the gas or the gas flow to the component part or through the component part.

9. The method according to claim 8, **characterized in that** a pulsed pressure progression takes place during the coating process.

10. The method according to any one of the preceding claims, **characterized in that** the gas flow is fed to a soldering furnace in which the heat exchanger has been soldered prior to feeding the gas flow.

11. The method according to any one of the preceding claims, **characterized in that** a silane, a silicon tetrachloride and/or at least one organosilicon compound such as siloxane or silicon tetraacetate are/is used as a reactive gas for producing a silicon dioxide layer.

12. The method according to any one of the preceding claims, **characterized in that** titanium chloride and/or at least one organometallic, in particular, organotitanium compound such as titanium tetraethylate or titanium tetraisopropylate are used or is used as a reactive gas for producing a titanium dioxide layer.

## Revendications

1. Procédé de fabrication d'un composant d'un circuit d'un milieu en circulation, tels que des composants d'un circuit de liquide de refroidissement, de fluide frigorigène ou de gaz d'échappement, ou bien d'un échangeur de chaleur, d'une soupape et/ou de leurs éléments constitutifs, où le composant présente au moins une surface qui est dotée d'un revêtement, **caractérisé en ce qu'**un flux de gaz tempéré et chargé au moins d'un constituant réactif gazeux est guidé jusqu'à la surface - également tempérée - du composant, où le flux de gaz réagit, au moyen du procédé de dépôt chimique en phase vapeur (CVD), pour former au moins une couche de protection solide sur la surface tempérée, où le flux de gaz, à la suite d'un processus d'assemblage du composant, par continuité de matière, à la suite d'un processus de brasage, d'un processus de soudage ou d'un processus d'assemblage mécanique, est guidé jusqu'à la surface du composant.

2. Procédé selon la revendication 1, **caractérisé en ce que** la surface du composant à recouvrir est portée à une température supérieure à celle du flux de gaz.

3. Procédé selon l'une ou l'autre des revendications précédentes, **caractérisé en ce que** la surface du composant est portée à une température allant de 100 degrés à 600 degrés Celsius, en particulier allant de 300 degrés à 550 degrés Celsius, en particulier allant de 350 degrés à 450 degrés Celsius, ladite surface étant portée à une température de préférence de 400°C.

4. Procédé selon l'une quelconque des revendications 1 à 3, **caractérisé en ce que** le dispositif de chauffage est un dispositif de chauffage par induction.

5. Procédé selon l'une quelconque des revendications 1 à 4, **caractérisé en ce qu'**une dépression est appliquée au four ou au dispositif de chauffage.

6. Procédé selon la revendication 5, **caractérisé en ce que** la pression est comprise entre 101300 pascals et 100 pascals ou entre 100 pascals et 1 pascal, en particulier entre 1 pascal et 0,001 pascal.

7. Procédé selon l'une quelconque des revendications précédentes, **caractérisé en ce que** le flux de gaz est fourni directement au composant ou bien est fourni par le composant lui-même.

8. Procédé selon l'une quelconque des revendications précédentes, **caractérisé en ce que** la dépression est utilisée pour aspirer le gaz ou le flux de gaz jusqu'au composant ou à travers le composant.

9. Procédé selon la revendication 8, **caractérisé en ce qu'**il se produit, au cours du processus de revêtement, une évolution des pulsations de pression.

10. Procédé selon l'une quelconque des revendications précédentes, **caractérisé en ce que** le flux de gaz est fourni à un four à braser dans lequel l'échangeur de chaleur a été brasé avant la fourniture du flux de gaz.

11. Procédé selon l'une quelconque des revendications précédentes, **caractérisé en ce que** l'on utilise comme gaz réactif, pour la production d'une couche de dioxyde de silicium, un silane, du tétrachlorure de silicium et/ou au moins un composé organique du silicium tel que des siloxanes ou du tétraacétate de silicium.

12. Procédé selon l'une quelconque des revendications précédentes, **caractérisé en ce que** l'on utilise comme gaz réactif, pour la production d'une couche de dioxyde de titane, du chlorure de titane et/ou au moins un composé organométallique, en particulier un composé organique du titane tel que du tétraéthylate de titane ou du tétraisopropylate de titane.
